# EUROPÄISCHE PATENTSCHRIFT

(11) **EP 0 517 133 B1**
(45) Veröffentlichungstag und Bekanntmachung des Hinweises auf die Patenterteilung: **10.05.1995**
(21) Anmeldenummer: 92109183.1
(22) Anmeldetag: 01.06.1992
(51) Int. Cl.: H05K 9/00

(54) **Kontaktfederstreifen**
Contact spring strips
Bandes élastiques de contact

(30) Priorität: 06.06.1991 DE 9106954 U
(43) Veröffentlichungstag der Anmeldung: 09.12.1992
(73) Patentinhaber: SIEMENS AKTIENGESELLSCHAFT, 80333 München (DE)
(72) Erfinder: Niggl, Heinz, W-8134 Pöcking (DE)

(56) Entgegenhaltungen:
- EP-A- 0 207 226
- EP-A- 0 425 193
- DE-U- 8 626 126
- GB-A- 2 183 920

## Beschreibung

Die Erfindung betrifft einen Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist.

Derartige Kontaktfederstreifen sind z. B. aus dem deutschen Gebrauchsmuster G 86 26 126 bekannt. Diese Kontaktfederstreifen sind durchgehend streifenförmig und in Längsrichtung gewölbt ausgebildet und besitzen an ihren Längskanten krallenartige Fortsätze.

Ein Nachteil dieser bekannten Kontaktfederstreifen besteht darin, daß sie in unterschiedlichen festen Längen hergestellt werden, was zu einem erheblichen Produktionsaufwand und zu einer großen Lagerhaltung zwingt. Ein weiterer Nachteil ist dadurch gegeben, daß eine in Längsrichtung verlaufende leichte Wölbung produktionstechnisch schwierig herzustellen ist.

Es ist nun Aufgabe der vorliegenden Erfindung, Kontaktfederstreifen der eingangs genannten Art so auszubilden, daß diese einfach und kostengünstig herstellbar sind und in beliebigen Längen verwendbar sind.

Dies wird dadurch erreicht, daß der Kontaktfederstreifen aus einer Vielzahl von einzelnen, durch Trennstege miteinander verbundenen Kontaktfedern besteht, wobei die einzelne Kontaktfeder aus einem von zwei in die gleiche Richtung abgewinkelten Schenkeln begrenzten Planmittelbereich besteht, wobei der äußere Randbereich des ersten Schenkels auf seiner gesamten Länge einwärts abgebogen ist, und der zweite Schenkel trapezförmig auslaufend gestaltet ist, wobei ein Teil seines äußeren Randbereichs als einwärts gebogener Federhaken ausgebildet ist.

Durch die Vermeidung einer in Längsrichtung des Kontaktfederstreifens verlaufenden Wölbung ist der erfindungsgemäße Kontaktfederstreifen leicht herzustellen. Dadurch, daß der Kontaktfederstreifen in eine Vielzahl von einzelnen Kontaktfedern, die mittels Trennstege miteinander verbunden sind, unterteilt ist, kann der Kontaktfederstreifen gemäß der vorliegenden Erfindung in beliebiger Länge als sogenannte "Meterware" hergestellt werden. Erst kurz vor der Montage kann der Kontaktfederstreifen auf einfache Art und Weise, nämlich durch einfaches Abbrechen, auf die gewünschte Länge gebracht werden.

Eine zweckmäßige Weiterbildung des erfindungsgemäßen Kontaktfederstreifens ist dadurch gekennzeichnet, daß im Bereich des ersten Schenkels zumindest ein vom Mittelbereich wegweisendes Dreieck herausgedrückt ist, dessen Spitze einwärts abgebogen ist. Dadurch wird eine bessere Kontaktierung des Kontaktfederstreifens mit dem Gehäuseteil, auf welchem der Kontaktfederstreifen befestigt ist, auch für den Fall einer leichten Korrosion erreicht.

Eine andere zweckmäßige Weiterbildung des Kontaktfederstreifens gemäß der vorliegenden Erfindung ist dadurch gekennzeichnet, daß eng benachbart zum Federhaken auf dem zweiten Schenkel eine auswärtsweisende Pocke angeordnet ist. Diese Pocke verhindert ein Anstoßen von auf die Kontaktfederleiste zu schiebenden Gehäuseteilen an den Kanten des Kontaktfederstreifens.

Eine weitere zweckmäßige Ausgestaltung des erfindungsgemäßen Kontaktfederstreifens ist dadurch gekennzeichnet, daß die Trennstege zwischen den planen Mittelbereichen der Kontaktfedern angeordnet sind, und daß im Bereich der Trennstege jeweils eine in Längsrichtung des Kontaktfederstreifens verlaufende längliche Prägung vorgesehen ist. Dadurch wird eine Versteifung des durchlaufenden Kontaktfederstreifens erreicht, wodurch ein besseres "Handling" des Kontaktfederstreifens gegeben ist.

Nachfolgend wird die Erfindung anhand eines in der Zeichnung dargestellten Ausführungsbeispiels näher erläutert. Es zeigt
- FIG 1: eine Aufsicht auf einen Teil eines gemäß der Erfindung gestalteten Kontaktfederstreifens, und
- FIG 2: einen Querschnitt durch eine Kontaktfeder des in FIG 1 gezeigten Kontaktfederstreifens.

Der in der Zeichnung dargestellte Kontaktfederstreifen 1 besteht aus einer Vielzahl von über Trennstege 3 miteinander verbundenen Kontaktfedern 2. Dadurch kann der Kontaktfederstreifen "endlos" gefertigt und anschließend aufgerollt werden. Erst bei der Montage wird der Kontaktfederstreifen durch einfaches Abschneiden von der Rolle auf die gewünschte Länge gebracht. Hierdurch entfällt die Lagerhaltung unterschiedlicher Längentypen.

Nachfolgend soll die einzelne Kontaktfeder näher beschrieben werden. Die im Ausführungsbeispiel dargestellte Kontaktfeder 2 besteht aus einem planen Mittelbereich 4, der von einem ersten Schenkel 5 und einem zweiten Schenkel 6 begrenzt wird. Der äußere Randbereich 7 des ersten Schenkels 5 ist auf seiner gesamten Länge einwärts abgebogen. Dieser abgebogene äußere Randbereich 7 dient zur Umfassung der Außenkante eines in der Zeichnung nicht dargestellten Gehäuseteils. Um eine bessere Kontaktierung zwischen Kontaktfeder 2 und dem Gehäuseteil zu erreichen, ist innerhalb des ersten Schenkels 5 zumindest ein nach außen weisendes Dreieck 9 herausgedrückt, dessen Spitze einwärts abgebogen ist. Besonders auf unedlen Oberflächen der Gehäuseteile wird so eine sichere Kontaktierung erreicht.

Der zweite Schenkel 6 der Kontaktfeder 2 ist trapezförmig auslaufend gestaltet, wodurch sich ein größerer Federweg ergibt. Ein Teil des äußeren Randbereichs des zweiten Schenkels 6 ist als einwärts gebogener Federhaken 8 ausgebildet, der in Öffnungen des Gehäuseteils eingreift. In unmittelbarer Nachbarschaft zu den Federhaken 8 sind auswärts weisende Pocken 10 vorgesehen. Diese Pocken verhindern beim Aufschieben eines zweiten Gehäuseteils auf den Kontaktfederstreifen ein Anstoßen des aufzuschiebenden Gehäuseteils gegen die Kanten des zweiten Schenkels 6.

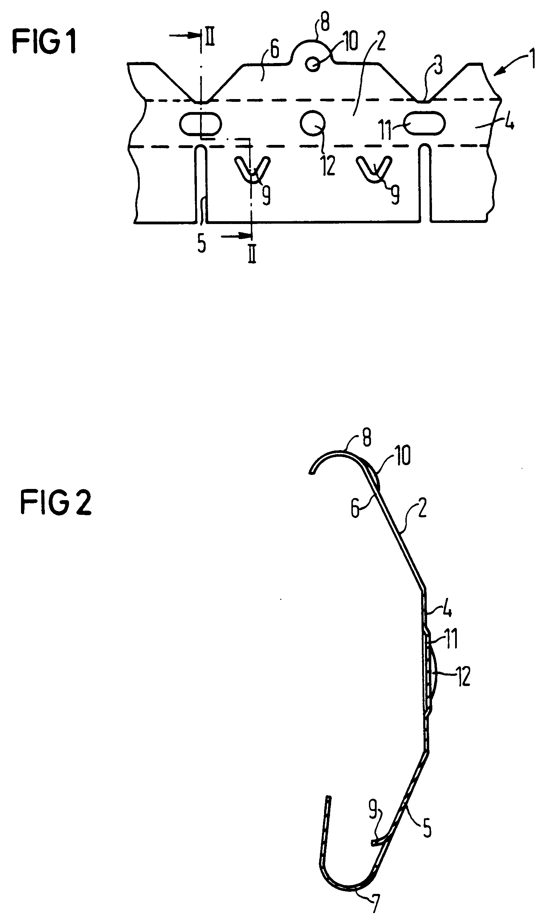

Dabei ermöglichen große Biegeradien - wie aus FIG 2 zu ersehen ist - die Anwendung weniger gut biegbarer, jedoch preiswerter Materialien. Im eingebauten Zustand ist die erfindungsgemäße Kontaktfeder vorgespannt, so daß sich eine flachere Anlaufschräge für das aufzuschiebende Gehäuseteil und ein fester Sitz der Kontaktfeder ergeben.

Im Bereich der Trennstege 3 ist eine als Längswarze ausgebildete Prägung 11 vorgesehen, wodurch eine Versteifung des durchlaufenden Kontaktfederstreifens erreicht wird. Innerhalb des Mittelbereiches 4 der Kontaktfeder 2 ist eine Warze 12 zur Erzielung eines definierten, hohen Kontaktdrucks vorgesehen.

## Patentansprüche

1. Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist,
**dadurch gekennzeichnet,**
daß der Kontaktfederstreifen (1) aus einer Vielzahl von einzelnen, durch Trennstege (3) miteinander verbundenen Kontaktfedern (2) besteht, wobei die einzelne Kontaktfeder (2) aus einem von zwei in die gleiche Richtung abgewinkelten Schenkeln (5, 6) begrenzten planen Mittelbereich (4) besteht, wobei der äußere Randbereich des ersten Schenkels (5) auf seiner gesamten Länge einwärts abgebogen ist, und der zweite Schenkel (6) trapezförmig auslaufend gestaltet ist, wobei ein Teil seines äußeren Randbereichs als einwärts gebogener Federhaken (8) ausgebildet ist.

2. Kontaktfederstreifen nach Anspruch 1,
**dadurch gekennzeichnet,**
daß im Bereich des ersten Schenkels (5) zumindest ein vom Mittelbereich (4) wegweisendes Dreieck (9) herausgedrückt ist, dessen Spitze einwärts abgebogen ist.

3. Kontaktfederstreifen nach Anspruch 1 oder 2,
**dadurch gekennzeichnet,**
daß eng benachbart zum Federhaken (8) auf dem zweiten Schenkel (6) eine auswärts weisende Pocke (10) angeordnet ist.

4. Kontaktfederstreifen nach einem der vorhergehenden Ansprüche,
**dadurch gekennzeichnet,**
daß die Trennstege (3) zwischen den planen Mittelbereichen (4) der Kontaktfedern (2) angeordnet sind, und daß im Bereich der Trennstege (3) jeweils eine in Längsrichtung des Kontaktfederstreifens (1) verlaufende längliche Prägung (11) vorgesehen ist.

## Claims

1. Contact spring strip for electromagnetically sealing housing parts of a screening housing, it being possible to contact the contact spring strip to respectively two of the housing parts, characterized in that the contact spring strip (1) comprises a multiplicity of individual contact springs (2) connected to one another by separating webs (3), the individual contact springs (2) comprising a planar middle region bounded by two legs (5, 6) bent in the same direction, the outer edge region of the first leg (5) being inwardly bent over its entire length and the second leg (6) being configured to finish in the shape of a trapeze, a part of its outer edge region being constructed as an inwardly bent spring hook (8).

2. Contact spring strip according to Claim 1, characterized in that at least one triangle (9) pointing away from the middle region (4) is pressed out in the region of the first leg (5) and its apex is inwardly bent.

3. Contact spring strip according to Claim 1 or 2, characterized in that an outwardly pointing pock (10) is arranged on the second leg (6) in close proximity to the spring hook (8).

4. Contact spring strip according to one of the preceding claims, characterized in that the separating webs (3) are arranged between the planar middle regions (4) of the contact springs (2), and in that an oblong stamping (11) extending in the longitudinal direction of the contact spring strip (1) is provided in each case in the region of the separating webs (3).

## Revendications

1. Bande élastique de contact pour protéger, du point de vue électromagnétique, des éléments d'un boîtier de protection, la bande élastique de contact pouvant être placée en contact respectivement avec deux des parties du boîtier, caractérisée par le fait que la bande élastique de contact (1) est constituée par une multiplicité de ressorts individuels de contact (2), qui sont reliés entre eux par des barrettes de séparation (3), les différents ressorts de contact (2) étant constitués par une partie centrale plane (4) limitée par deux branches (5,6) qui sont coudées dans la même direction, la partie marginale extérieure de la première branche (5) étant repliée de façon rentrante sur toute sa longueur, tandis que la seconde branche (6) est réalisée de manière à se terminer par une forme trapézoïdale, un élément de sa partie marginale extérieure étant agencé sous la forme d'un crochet élastique (8) replié vers l'intérieur.

2. Bande élastique de contact suivant la revendication 1, caractérisée par le fait qu'au moins un triangle (9), qui s'étend à partir de la zone centrale (4) et dont la pointe est repliée vers l'intérieur, est ressorti au niveau de la première branche (5).

3. Bande élastique de contact suivant la revendication 1 ou 2, caractérisée par le fait qu'un bossage (10) dirigé vers l'extérieur est disposé au voisinage immédiat du crochet élastique (8) sur la seconde bande (6).

4. Bande élastique de contact suivant l'une des revendications précédentes, caractérisée par le fait que les barrettes de séparation (3) sont disposées entre les zones centrales planes (4) des ressorts de contact (2) et que respectivement une partie gaufrée allongée (11), qui s'étend dans la direction longitudinale de la bande élastique de contact (1), est prévue au niveau de la barrette de séparation (3).
